Europäisches Patentamt

European Patent Office

Office européen des brevets

(11) Publication number: **0 595 013 A2**

# EUROPEAN PATENT APPLICATION

(21) Application number: **93115039.5**

(22) Date of filing: **18.09.93**

(51) Int. Cl.⁵: **H03L 7/099**

(30) Priority: **30.10.92 ES 9202194**

(43) Date of publication of application:
**04.05.94 Bulletin 94/18**

(84) Designated Contracting States:
**BE DE FR GB IT NL PT**

(71) Applicant: **ALCATEL STANDARD ELECTRICA, S.A.**
**Ramirez de Prado, 5/6**
**E-28045 Madrid(ES)**

(72) Inventor: **Perez Calpena, Diego Enrique**
**C/ Pico de los Artilleros 42, 1.A**
**E-28030 Madrid(ES)**
Inventor: **Ramos Font, Monica**
**Avda, Doctor Garcia Tapia 141, 8.B**
**E-28030 Madrid(ES)**

(74) Representative: **Pohl, Herbert, Dipl.-Ing et al**
**Alcatel SEL AG**
**Patent- und Lizenzwesen**
**Postfach 30 09 29**
**D-70449 Stuttgart (DE)**

(54) **Digital frequency synthesizer.**

(57) That uses a numerically controlled oscillator (1) to which a reference signal ($f_{ref}$) and a programming signal (PROG) are applied in such a way that, from the reference signal an output signal ($f_{out}$) is generated with a frequency that depends on the value of the programming signal.

It is characterized in that it comprises a control unit (6) whose output is connected to the programming input (PROG) of the numerically controlled oscillator (1), and to which are applied: an external signal ($f_{ext}$), both directly and through a counter (5) that counts the pulses in the external signal, and the output signal from the numerically controlled oscillator (1), through a counter (4) that counts the pulses in the output signal; the purpose of the foregoing being to apply a variable signal to the programming input of the numerically controlled oscillator (1) that compensates for the variations in the reference signal frequency and to obtain an output signal with a frequency as accurate and stable as that of the external signal.

FIG. 2

## OBJECT OF THE INVENTION

The invention, as stated in the title, refers to a digital frequency synthesizer that employs a numerically controlled oscillator (NCO) to which a reference signal and a programming signal are applied such that, from the reference signal an output signal is generated with a frequency that depends on the value of the programing signal; and which has the object of compensating the variations in the frequency of the reference signal and obtaining an output signal with a frequency with an accuracy and stability better than those of the reference signal frequency.

## BACKGROUND TO THE INVENTION

The problem of obtaining signals with very accurate and stable frequencies has traditionally been overcome by means of extremely accurate and stable Cesium and Rubidium standards. This solution is economically very costly in systems where very accurate frequencies have to be generated at several points.

On the other hand, in digital electronics, increasing use has been made of numerically controlled oscillators (NCO) in order to carry out direct digital synthesizing. These numerically controlled oscillators provide a wide range of frequencies, with an accuracy and stability equal to those of the reference signal frequency applied to these oscillators; however, inherently, they can never achieve greater accuracy and stability than those of the reference signal frequency.

## TECHNICAL PROBLEM TO BE OVERCOME

Consequently, the technical problem to be overcome consists in obtaining a signal with a frequency with an accuracy and stability better than those of the reference signal frequency.

## CHARACTERIZATION OF THE INVENTION

To overcome all the drawbacks outlined above, the invention consists of a digital frequency synthesizer that uses a numerically controlled oscillator to which a reference signal and a programming signal are applied, in such a way that, from the reference signal, an output signal is generated with a frequency that depends on the value of the programming signal; and it is characterized in that it comprises a first counter that counts the pulses corresponding to an external signal with a highly accurate and stable frequency, and whose output is applied to a control unit; in that also comprises a second counter that counts the pulses corresponding to the output signal generated by the numerically controlled oscillator and whose output is also connected to the control unit. This control unit also receives directly the external signal with a highly accurate and stable frequency such that it provides, at its output, a programming signal whose value, at any given moment, and after an initialization, depends on a defined correcting criterion that takes into account the result of the calculation of the frequency shift in the output signal obtained by the control unit from an analysis of the content of the counters. All of this with the object of compensating the variations in the reference signal frequency and producing an output signal with a frequency as accurate and stable as that of the external signal.

In addition, the invention is characterized in that the control unit comprises:

- an interruption generator that receives the external signal whose frequency is highly accurate and stable, and which is connected to a microprocessor from which it receives the programmable value of the period with which it has to interrupt the microprocessor itself, and to which it transmits the interruption signal;
- a first cyclic storage register for the content of the first pulse counter of the external signal, which also receives the external signal that controls said storage, and that is connected to the microprocessor;
- a second cyclic storage register for the content of the second pulse counter of the output signal, which also receives the external signal that controls said storage, and that is connected to the microprocessor;
- a storage register in which the microprocessor writes the new value of the programming signal, when it is necessary to change it, and the output of which is connected to the input of the numerically controlled oscillator.

The invention is also characterized in that the microprocessor and its associated memory, which is connected to the storage register with the value of the programming signal, when it is interrupted by the interruption signal coming from the interruption generator, has access to the cyclic shift registers holding the content of the counters, in order to read the stored data that are used to calculate the shift in the reference frequency and set the new value of the programming signal in accordance with the correcting criterion.

Another characteristic of the invention is that the interruption generator is formed by a programmable register in which the microprocessor programs the period with which the interruption signal is generated; by a pulse counter for the external signal that is received directly; and by a comparator that is connected to both, for the purpose of comparing their contents and generating the interruption signal to apply to the microprocessor when both contents are the same.

In a preferred implementation the external signal, whose frequency is highly accurate and stable, consists of a signal at one pulse per second obtained from a Global Positioning System (GPS) satellite receiver.

The invention is adaptable over a wide range of frequencies, permitting signals to be obtained with highly stable frequencies; and all this at a reasonable cost.

On the other hand, it has the inconvenience that the frequencies obtained by direct digital synthesis coincide, on average, with those that it is desired to obtain, but it can be that this is not obtained instantaneously. The fact that the corrections to the generated frequency are done in determined moments of time, can give rise to not obtaining the accuracy required at certain instants.

Below, in order to permit a better understanding of this document, and forming an integral part thereof, a number of figures is attached in which, by way of illustration and in no way limiting, the purpose of the invention is shown.

## BRIEF FOOTNOTES TO THE FIGURES

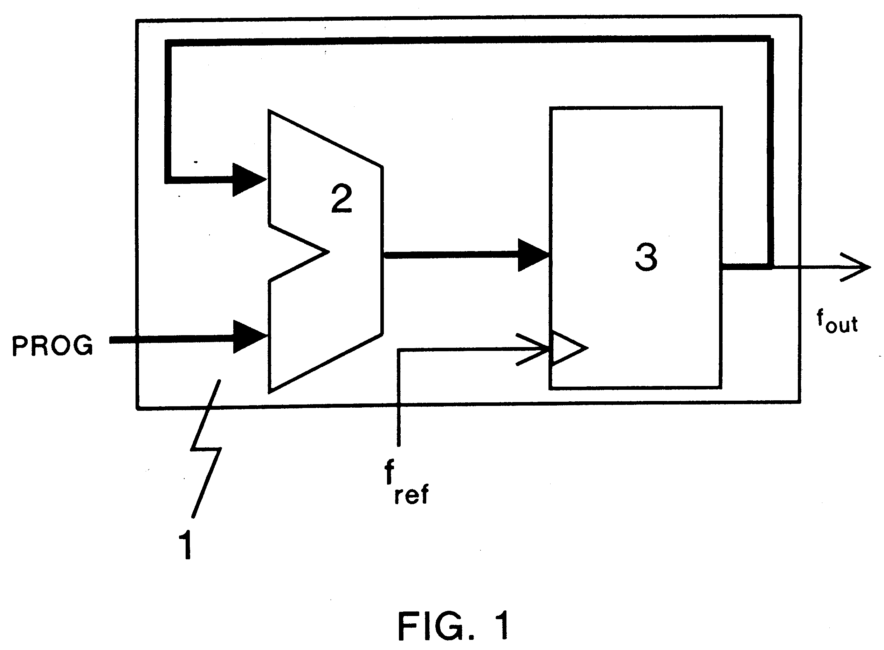

Figure 1 shows a block diagram of a numerically controlled oscillator, of conventional type.

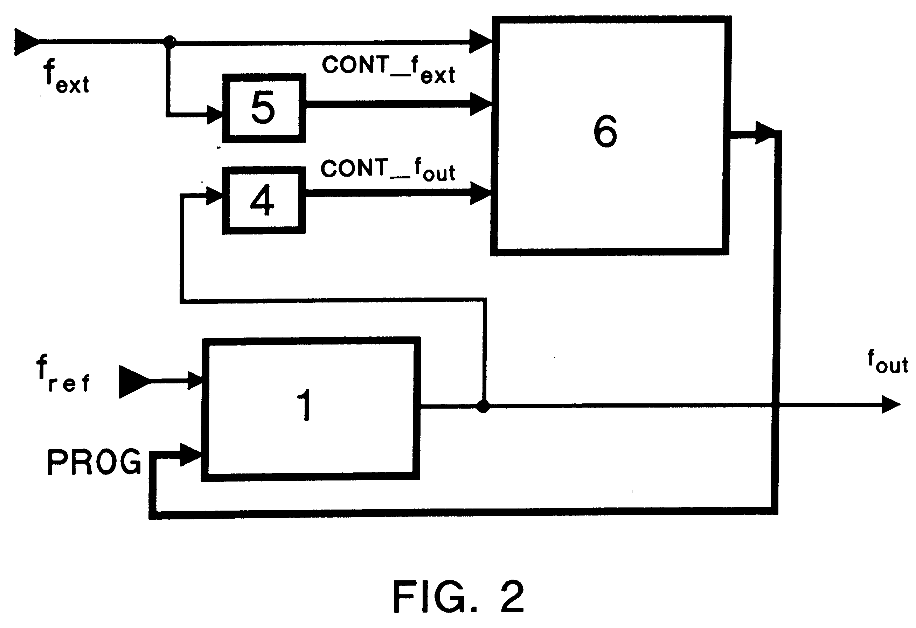

Figure 2 shows a block diagram of the digital frequency synthesizer object of the invention.

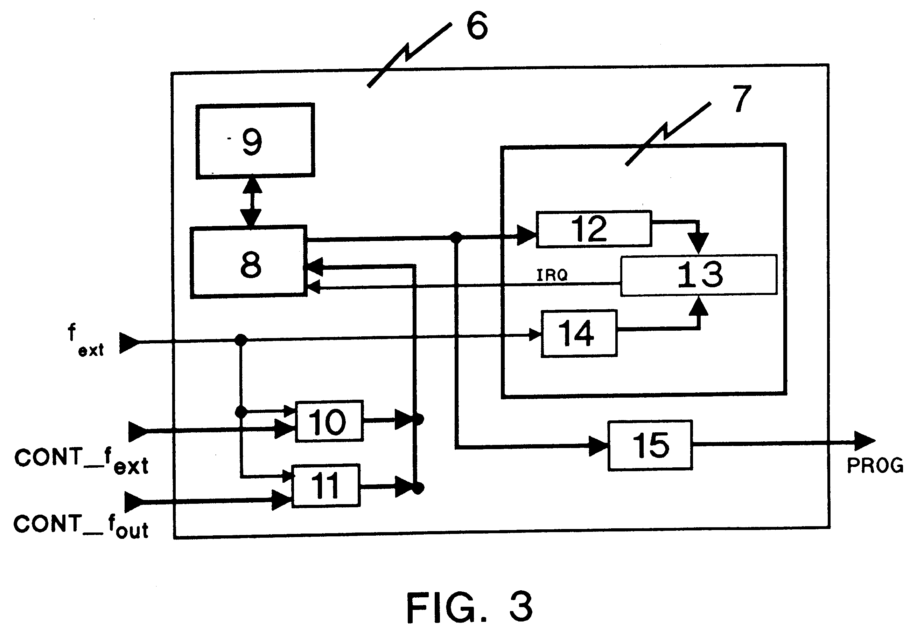

Figure 3 shows a block diagram of the control unit of the digital frequency synthesizer of the invention.

## DESCRIPTION OF A PREFERRED IMPLEMENTATION

Below, a description is given of the invention based on the figures mentioned above.

The digital frequency synthesizer of the invention uses a numerically controlled oscillator 1 to which a reference signal $f_{ref}$ and a programming signal PROG are applied, in such a way that, from the reference signal $f_{ref}$, an output signal $f_{out}$ is generated with a frequency that depends on the value of the programming signal PROG.

The output of the numerically controlled oscillator 1 is connected to a counter 4 that counts the pulses corresponding to the output signal $f_{out}$, and whose output is connected to a control unit 6.

In addition, the control unit 6 is connected to an external signal $f_{ext}$, directly and through another counter 5 that counts the pulses corresponding to the external signal $f_{ext}$.

The frequency of the external signal $f_{ext}$ must have an accuracy and stability that are at least equal to that required for the frequency of the output signal $f_{out}$ and a much lower value. In the preferred example of implementation, this external signal $f_{ext}$ consists of a signal of one pulse per second obtained from a Global Positioning System (GPS) satellite receiver.

The control unit 6 includes a register 11 through which the connection to the counter 4 that counts the pulses corresponding to the output signal $f_{out}$ is made.

In addition, the control unit 6 has a second register 10 through which the connection to the counter 5 that counts the pulses corresponding to the external signal $f_{ext}$ is made.

Both registers 10 and 11 directly receive the external signal $f_{ext}$ that controls the storage of the contents of these counters in the registers.

On the other hand, the control unit 6 has a microprocessor 8 and its associated memory 9. The microprocessor 8 is connected to the registers 10 and 11 and to an interruption generator 7, also included in the control unit 6.

The interruption generator 7 is formed by a programmable register 12 that is connected to the microprocessor 8 so that the latter programs the period with which the interruptions IRQ are generated.

In addition, the interruption generator 7 has a counter 14 that directly receives the external signal $f_{ext}$.

Both the counter 14 and the programmable register 12 are connected to a comparator 13 that generates the interruption signal IRQ when the contents of the programmable register 12 and of the counter 14 are equal, and that is also connected directly to the microprocessor 8 to which this IRQ signal is sent.

The control unit 6 includes a storage register 15 that is connected to the microprocessor 8 in order to store the value of the programming signal PROG according to the criterion described below. The storage register 15 is also connected to the PROG input of the numerically controlled oscillator 1.

As has been mentioned above, the numerically controlled oscillator 1 consists of a programmable circuit which, from the reference signal $f_{ref}$ generates an output signal $f_{out}$, whose frequency depends on the programmed value.

Basically the numerically controlled oscillator 1 is formed by an adder 2 in which the sum of two n-bit binary numbers is made, one of which is the value of the programing signal PROG and the other is the actual output fed back through a register consisting of three flip-flops.

The number of bits n, is a function of the accuracy required:

$$n = INT.[1g_2 . 1/accuracy] + 1.$$

The programming signal necessary to produce a given output frequency $f_{out}$ is obtained from the following expression:

$$PROG = 2^n . f_{out}/f_{ref}.$$

Therefore if $f_{ref}$ varies, PROG can be modified in order to keep $f_{out}$ constant.

Consequently, the purpose of the control unit 6 is to calculate, cyclically, the value of the programming signal PROG necessary to obtain a given output frequency $f_{out}$.

The calculation of the value of the programming signal PROG is done in the following phases:

## PHASE 1: STARTING THE NUMERICALLY CONTROLLED OSCILLATOR

At the outset the initial programming PROG_0 is made in order to obtain the desired output frequency $f_{out}$; consequently the following value is set in the control unit 6:

$$PROG\_0 = 2^n . f_{out}/f_{ref}.$$

## PHASE 2: QUANTIFYING THE SHIFT

In this phase, in synchronism with the external signal, a calculation of the variation or shift experienced by the reference signal frequency $f_{ref}$ is made. This function is done by means of the counter 4 that counts the pulses in the output signal $f_{out}$, whose output is referred to as CONT_$f_{out}$, and by means of the counter 5 that counts the pulses in the external signal $f_{ext}$, whose output is referred to as CONT_$f_{ext}$. These outputs are stored in the registers 10 and 11, with the same frequency as the external signal $f_{ext}$.

The microprocessor 8 reads these data each time an interruption signal IRQ is received from the comparator 13, and calculates the shift D according to the following equation:

$$D = CONT\_f_{out} - (f_{out}/f_{ext}) . CONT\_f_{ext}$$

where CONT_$f_{ext}$ represents the value of the register 10, and CONT_$f_{out}$ represents the value of register 11.

## PHASE 3: SHIFT CORRECTION. REPROGRAMMING OF THE NUMERICALLY CONTROLLED OSCILLATOR.

Once the shift has been calculated, the numerically controlled oscillator 1 is reprogrammed, if necessary, in accordance with the following correction criterion:

- if the shift is zero, the programming remains the same; that is, if D = 0, the programming signal PROG is left unchanged;
- if the shift is minimal, D = ±1, the minimum correction is made, namely:

$$PROG = PROG\_previous \mp 1; and$$

- if the absolute value of the shift is greater than 1, then:

$$PROG = PROG\_0 . (f_{out} .CONT\_f_{ext} )/(f_{ext} .CONT\_f_{out})$$

The correction criterion for shift D takes into account the difference due to the fact that the external signal and the reference signal are not synchronous, since they have different sources. In addition, it takes into account the minimum frequency correction permitted by the numerically controlled oscillator 1.

The entire operation is managed by the microprocessor 8 which oversees the control process in accordance with the data processing commands indicated in the memory 9.

In phase 1, the microprocessor 8 accesses the storage register 15 in order to write the programming necessary to permit the desired output frequency to be obtained.

Similarly, in phase 2, the interruption generator 7 interrupts the microprocessor 8 so that the latter can have access to the registers 10 and 11 in order to read their contents, as already mentioned. After this operation, the microprocessor 8 processes the content of these registers according to the equation indicated for this phase. In this way the shift is quantified.

Finally, in phase 3, in line with the correction criterion described, the microprocessor 8 writes, or does not write, in the shift register 15; in this way the numerically controlled oscillator 1 will have a new programming signal applied to its input PROG.

Thus, by means of the invention, an output signal is obtained that has a frequency with the same accuracy and stability as that of the external signal $f_{ext}$.

Both in the description made, and in the supporting figures, the initializing and reinitializing processes of the various counters and registers have been omitted for reasons of simplicity and clarity.

These processes are well known to any man skilled in digital systems and require no additional explanation. It need only be pointed out that all the counters and registers are initialized when the system starts up, and counters 4 and 5 are also reinitialized each time the value of the programming signal PROG is changed.

**Claims**

1. **DIGITAL FREQUENCY SYNTHESIZER**, that uses a numerically controlled oscillator (1) to which a reference signal ($f_{ref}$) and a programming signal (PROG) are applied in such a way that, from the reference signal ($f_{ref}$), an output signal ($f_{out}$) is generated with a frequency that depends on the value of the programming signal (PROG), <u>characterized:</u>
   - in that it comprises a first counter (5) that counts the pulses corresponding to an external signal ($f_{ext}$) with a highly accurate and stable frequency, and whose output is applied to a control unit (6);
   - in that it comprises a second counter (4) that counts the pulses corresponding to the output signal ($f_{out}$) generated by the numerically controlled oscillator (1), and whose output is also connected to the control unit (6);
   - in that the control unit (6) also receives directly the external signal ($f_{ext}$) with a highly accurate and stable frequency and provides, at its output, a programming signal (PROG) whose value, at any given moment, and after an initialization, depends on a defined correction criterion that takes into account the result of the calculation of the frequency shift in the output signal ($f_{out}$) obtained by the control unit (6) from an analysis of the content of the counters (4, 5), with the object of compensating the variations in the reference signal frequency ($f_{ref}$) and producing an output signal ($f_{out}$) with a frequency as accurate and stable as that of the external signal ($f_{ext}$).

2. **DIGITAL FREQUENCY SYNTHESIZER** according to claim 1, <u>characterized:</u>
   - in that the control unit (6) comprises an interruption generator (7) that receives the external signal ($f_{ext}$), whose frequency is highly accurate and stable, and which is connected to a microprocessor (8) from which it receives the programmable value of the period with which it has to interrupt the microprocessor itself, and to which it transmits the interrupt signal (IRQ);
   - in that the control unit (6) also has a first cyclic storage register (10) for the content of the first pulse counter (5) of the external signal ($f_{ext}$), which also receives the external signal ($f_{ext}$) that controls said storage, and that is connected to the microprocessor (8);
   - in that the control unit (6) also has a second cyclic storage register (11) for the content of the second pulse counter (4) of the output signal ($f_{out}$), which also receives the external signal ($f_{ext}$) that controls said storage, and that is connected to the microprocessor (8);
   - in that the microprocessor (8) and its associated memory (9) are also connected to a storage register (15) with the value of the programming signal (PROG), and in that, when it is interrupted by the signal (IRQ) coming from the interruption generator (7), has access to the cyclic storage registers (10, 11) in order to read their contents and calculate the shift in the reference frequency and set the new value of the programming signal (PROG) in accordance with the correction criterion;
   - in that the microprocessor (8) writes the new value of the programming signal (PROG) into the storage register (15), when it is necessary to modify it, its output being connected to the input of the numerically controlled oscillator (1).

3. **DIGITAL FREQUENCY SYNTHESIZER** according to claim 2, <u>characterized</u> in that the interruption generator (7) consist of:
   - a programmable register (12) in which the microprocessor (8) programs the period with which the interruption signal (IRQ) is generated;
   - a pulse counter (14) for the external signal ($f_{ext}$) that is received directly; and
   - a comparator (13) that compares the contents of the programmable register (12) and the counter (14) and that, when both contents are the same, generates the interruption signal (IRQ) to apply to the microprocessor (8).

4. **DIGITAL FREQUENCY SYNTHESIZER** according to claim 1, <u>characterized</u> in that the preferred correction criterion for the programming signal (PROG) as a function of the frequency shift (D) in the reference signal ($f_{ref}$) is:
   - if D = 0, the programming signal (PROG) is unchanged;
   - if D = -1, PROG = PROG_previous + 1;
   - if D = + 1, PROG = PROG_previous - 1; and
   - if $|D| > 1$, PROG = PROG_0.($f_{out}$ .CONT_$f_{ext}$ )/$f_{ext}$ .CONT_$f_{out}$)

where:

PROG__0

= initial value of the programming signal

$f_{out}$

= value of the desired output signal frequency

$f_{ext}$

= value of the highly accurate and stable external frequency

CONT__$f_{ext}$

= value in register (10),

CONT__$f_{out}$

= value in register (11).

5.   **DIGITAL FREQUENCY SYNTHESIZER** according to claim 1, **characterized** in that in a preferred implementation the external signal ($f_{ext}$), with a frequency that is highly accurate and stable, consists of a signal at one pulse per second obtained from a Global Positioning System (GPS) satellite receiver.

FIG. 1

EP 0 595 013 A2

FIG. 2

EP 0 595 013 A2

EP 0 595 013 A2

FIG. 3